# EUROPEAN PATENT APPLICATION

(11) **EP 1 369 937 A2**
(43) Date of publication of application: **10.12.2003**
(21) Application number: 03076545.7
(22) Date of filing: 22.05.2003
(51) Int. Cl.: H01L 51/20

(54) **Sputtered cathode for an organic light-emitting device having an alkali metal compound in the device structure**

(30) Priority: 03.06.2002 US 161586
(71) Applicant: EASTMAN KODAK COMPANY (a New Jersey corporation), Rochester, New York 14650 (US)
(72) Inventor: Raychaudhuri, Pranab Kumar, Eastman Kodak Company, Rochester, New York 14650-2201 (US); Madathil, Joseph Kuru, c/o Eastman Kodak Company, Rochester, New York 14650-2201 (US); Liao, Liang-Sheng, Rochester, New York 14650-2201 (US)
(74) Representative: Weber, Etienne Nicolas

(57) **Abstract**

An OLED device, including a substrate, an anode formed of a conductive material over the substrate, an emissive layer having an electroluminescent material provided over the anode layer, a buffer layer, provided over the emissive layer and including a compound of an alkali metal or thermal decomposition products thereof, and a sputtered layer of a metal or metal alloy provided over the buffer layer and selected to function with the buffer layer to inject electrons.

## Description

The present invention relates to organic light-emitting diode devices and methods for making such devices, which use an inorganic buffer layer and a sputtered metal or metal alloy layer on such inorganic buffer layer.

Organic electroluminescent (OEL) device, alternately known as organic light-emitting diode (OLED), is useful in flat-panel display applications. This light-emissive device is attractive because it can be designed to produce red, green, and blue colors with high luminance efficiency, operable with a low driving voltage of the order of a few volts and viewable from oblique angles. These unique attributes are derived from a basic OLED structure comprising a multilayer stack of thin films of small-molecule organic materials sandwiched between an anode and a cathode. Tang and others in commonly assigned US-A-4,769,292 and US-A-4,885,211 have disclosed such a structure. The common electroluminescent (EL) medium is comprised of a bilayer structure of a hole-transport layer (HTL) and an electron-transport layer (ETL), typically of the order of a few tens of nanometer (nm) thick for each layer. The anode material is usually an optically transparent indium tin oxide (ITO) film on glass, which also serves as the substrate for the OLED. The cathode is typically a reflective thin film. Selection of electrode materials is based on work functions. ITO is most commonly used as the anode because it has a high work function. Mg:Ag alloys are generally used as electron-injecting contacts because they have lower work functions. Lithium containing alloys such as Al:Li and LiF/Al contacts also provide efficient electron injection. The device emits visible light in response to a potential difference applied across EL medium. When an electrical potential difference is applied at the electrodes, the injected carriers-hole at the anode and electron at the cathode-migrate towards each other through EL medium and a fraction of them recombine to emit light.

In the fabrication of OLEDs, a vapor deposition method is used. Using this method, the organic layers are deposited in thin-film forms onto ITO glass substrates in a vacuum chamber, followed by deposition of the cathode layer. Among the deposition methods for the cathode, vacuum deposition using resistive heating or electron-beam heating has been found to be most suitable because it does not cause damage to the organic layers. However, it would be highly desirable to avoid these methods for fabrication of cathode. This is because these processes are inefficient. In order to realize low cost manufacturing, one must adopt and develop a proven robust high-throughput process specific to OLED fabrication. Sputtering has been used as a method of choice for thin film deposition in many industries. Conformal, dense, and adherent coatings, short cycle time, low maintenance of coating chamber, and efficient use of materials are among few of the benefits of sputtering.

Sputtering is not commonly practiced for fabrication of the OLED cathodes because of the potential damage inflicted on the organic layers and the degradation of device performance. Sputter deposition takes place in a high energy and complex environment that is comprised of energetic neutrals, electrons, positive and negative ions, and emissions from the excited states that can degrade the organic layers upon which the cathode is deposited.

Liao and others (Appl. Phys. Lett. 75, 1619 [1999]) investigated using
x-ray and ultraviolet photoelectron spectroscopies the damages induced on Alq surfaces by 100 eV Ar + irradiation. It was revealed from core level electron density curves that some N-A1 and C-O-A1 bonds in Alq molecules were broken. The valance band structure was also tremendously changed implying the formation of a metal-like conducting surface. It was suggested that this would cause nonradiative quenching in OLEDs when electrons are injected into the Alq layer from the cathode and also would result in electrical shorts.

During sputter deposition of cathode, the Alq surface is subjected to high doses of Ar⁺ bombardments at several hundred volts. As shown by Hung and others (J. Appl. Phys. 86, 4607 [1999]), a dose only of 9 x 10¹⁴/cm² altered the valance band structure. Therefore, sputtering a cathode on Alq surface in Ar atmosphere is expected to degrade the device performance.

Sputtering damage is controllable, to some extent, by properly selecting the deposition parameters. European patent applications EP 0 876 086 A2, EP 0 880 305 A1, and EP 0 880 307 A2, Nakaya and others, of TDK Corporation, disclose a method of depositing a cathode by a sputtering technique. After depositing the organic layers, with vacuum still kept, the devices were transferred from the evaporation to a sputtering chamber wherein the cathode layer was deposited directly on the electron-transport layer. The cathode was an Al alloy comprised of 0.1 - 20 a% Li that additionally contained at least one of Cu, Mg, and Zr in small amounts, and in some cases had a protective overcoat. The OLED devices thus prepared using no buffer layer were claimed to have good adhesion at the organic layer/cathode interface, low drive voltage, high efficiency and exhibited a slower rate of development of dark spot. Grothe and others in Patent Application DE 198 07 370 C1 also disclosed a sputtered cathode of an Al:Li alloy which had relatively high Li content and having one or more additional elements chosen from Mn, Pb, Pd, Si, Sn, Zn, Zr, Cu, and SiC. In all of those examples no buffer layer was used, yet electroluminescent was produced at lower voltages. Sputtering damage was controlled possibly by employing a low deposition rate. It is easily anticipated that by lowering sputtering power the damage inflicted on the organic layers can be reduced. At low power, however, the deposition rate can be impracticably low and the advantages of sputtering are reduced or even neutralized.

To minimize damage during high speed sputtering of cathodes, a protective coating on the electron-transport layer can be useful. The protective layer, alternately termed as the buffer layer, must be robust to be effective. However, in addition to being resistant to plasma, a buffer layer must not interfere with the operation of the device and must preserve the device performance. Parthasarathy and others (Appl. Phys. Lett. 72, 2138 [1998]) reported an application of a buffer layer consisting of copper phthalocyanine (CuPc) and zinc phthalocyanine (ZnPc) during sputtering deposition of a metal free cathode. The buffer layer prevented damage to the underlying organic layers during the sputtering process. Hung and others (J. Appl. Phys. 86, 4607 [1999]) disclosed the application of CuPc buffer layers that permitted high energy deposition of alloy cathodes. The cathode contained a low work function component, Li, which was believed to diffuse through the buffer layer and provided an electron-injecting layer between the electron-transport layer and the buffer layer. EPO Patent Application 0 982 783 A2, Nakaya and others, disclosed a cathode of Al:Li alloy. The cathode was prepared by sputtering using a buffer layer constructed of a porphyrin or napthacene compound that was deposed between the electron-transport layer and the cathode. The device containing the sputtered electrode exhibited low drive voltage, high efficiency, and retarded dark spot growth. Although it was stated in all those references that efficient devices were made, none claimed to have eliminated the sputter damage.

Furthermore, the shortcomings of some of the prior art device structures are that they are not ideally suited for full color devices that emit in different colors. While CuPc is largely transparent in the blue-green region of wavelength, the transparencies particularly in the red wavelength region is substantially lower. To be useful in full color devices, the buffer layer should have fairly uniform transparency in the entire visible wavelength range. Another undesirable feature is that the organic buffer layers, such as phthalocyanine layers, are likely to be thick, requiring long deposition time.

It is therefore an object of the present invention to provide a cathode structure in an OLED device, which has relatively uniform response in the visible wavelength range, and provides electron-injection.

Another object of the present invention is to provide a cathode structure for an OLED device that offers significant protection against damage during sputtering deposition of cathode layer.

The above objects are achieved in an OLED device, comprising:
a) a substrate;
b) an anode formed of a conductive material over the substrate;
c) an emissive layer having an electroluminescent material provided over the anode layer;
d) a buffer layer, provided over the emissive layer and including a compound of an alkali metal or thermal decomposition products thereof; and
e) a sputtered layer of a metal or metal alloy provided over the buffer layer and selected to function with the buffer layer to inject electrons.

An advantage of the present invention is that damage to organic layers during sputtering is minimized, permitting cathode fabrication at high deposition rates.

Another advantage of the present invention is that the buffer layer/sputtered layer cathode is ideal for full color devices.
FIG. 1 shows schematically the layer structure of the OLED device;
FIG. 2 is a plot of performance of sputtered Mg cathode device vs. RbNO₃ buffer layer thickness;
FIG. 3 is a plot of performance of sputtered Mg cathode device vs. RbNO₃ buffer layer thickness in an extended range;
FIG. 4 is a plot of performance of sputtered Mg cathode device vs. CsNO₃ buffer layer thickness;
FIG. 5 is a plot of performance of sputtered Mg cathode device vs. Cs₂SO₄ buffer layer thickness;
FIG. 6 is a plot of performance of sputtered Mgcathode device vs. KIO₃ buffer layer thickness; and
FIG. 7 is a plot of performance of sputtered Mg cathode device vs. CsOOCCH₃ buffer layer thickness.

Throughout the ensuring description, acronyms are used to designate the names of different layers and operating features of organic light-emitting diode devices. For reference, they are listed in Table 1.

**Table 1**

| | |
|---|---|
| OLED | Organic light-emitting diode |
| ITO | Indium tin oxide |
| HIL | Hole-injection layer |
| HTL | Hole-transport layer |
| EML | Emissive layer |
| ETL | Electron-transport layer |
| NPB | 4,4'-Bis[N-(1-naphthyl)-N-phenylamino]biphenyl (NPB) |
| Alq | Tris(8-hydroxyquinoline) aluminum |
| LiF | Lithium Fluoride |
| RbNO₃ | Rubidium Nitrate |
| CsNO₃ | Cesium Nitrate |
| Cs2SO₄ | Cesium Sulfate |
| CsOOCCH₃ | Cesium Acetate |
| KIO₃ | Potassium Iodate |
| Al | Aluminum |
| Mg | Magnesium |

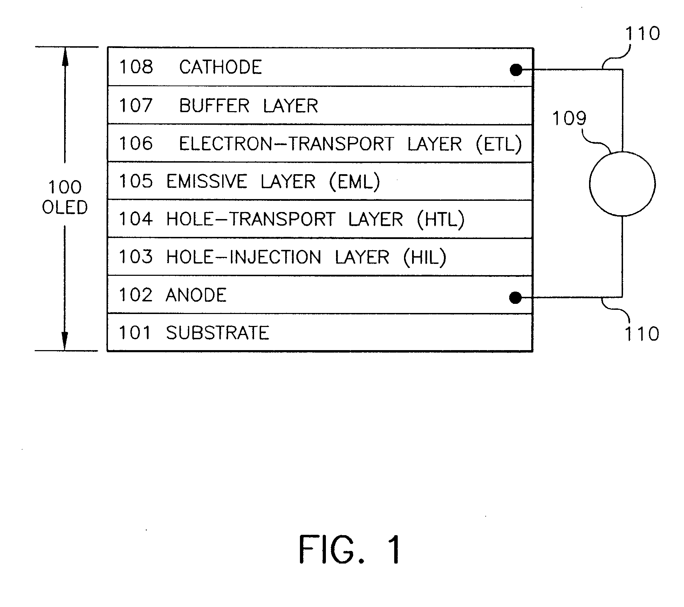

Turning now to FIG. 1, the OLED device 100 of this invention includes a substrate 101, an anode 102, a hole-injection layer (HIL) 103, a hole-transport layer (HTL) 104, an emissive layer (EML) 105, an electron-transport layer (ETL) 106, a buffer layer 107, and a sputtered cathode 108. In operation, the anode 102 and the sputtered cathode 108 are connected to a voltage source 109 via conductors 110 and electrical current is passed through the organic layers, resulting in light emission or electroluminescence from the OLED device 100. Depending on the optical transparency of the anode 102 and sputtered cathode 108, electroluminescence can be viewed from either the anode side or the cathode side. The intensity of the electroluminescence is dependent on the magnitude of the electrical current that is passed through the OLED device 100, which in turn is dependent on the luminescent and electrical characteristics of the organic layers as well as the charge-injecting nature of the anode 102 and sputtered cathode 108.

The composition and the function of the various layers constituting the OLED device 100 are described as follows.

Substrate 101 may include glass, ceramic, or plastics. Since the OLED device fabrication does not require high temperature process, any substrate that can withstand process temperatures of the order of 100°C is useful, which includes most thermal plastics. The substrate 101 may take the form of rigid plate, flexible sheet, or curved surfaces. Substrate 101 may include support with electronic backplane, and thus includes active-matrix substrates, which contain electronic addressing and switching elements. Examples of such active-matrix substrates include single-crystal silicon wafer with CMOS circuit elements, substrates with high temperature polysilicon thin-film-transistors, substrates with low temperature polysilicon thin-film-transistors. Those skilled in the art will appreciate that other circuit elements can be used to address and drive the OLED devices.

Anode 102 provides the function of injecting hole into the organic layer when a positive potential relative to the sputtered cathode 108 is applied to the OLED device 100. It has been shown, for example, in commonly assigned US-A-4,720,432, that indium tin oxide (ITO) forms efficient anode because it has a relatively high work function. Since ITO film itself is transparent, ITO coated glass provides an excellent support for the fabrication of OLED devices. Other suitable anode materials include high work function metals such as Au, Pt, Pd, or alloys of these metals.

Hole-injection layer (HIL) 103 provides the function of increasing the efficiency of the hole-injection from the anode 102 into the organic layers. It has been shown, for example in commonly assigned US-A-4,885,211, that a porphorinic or phthalocyanine compound is useful as a hole injection layer 103, resulting in increased luminance efficiency and operational stability. Other preferred HIL materials include CFx, which is a fluorinated polymer deposited by plasma-assisted vapor deposition, wherein x is less than or equal to 2 and greater than 0. The method of preparation and the characteristics of CFx have been disclosed in commonly assigned US-A-6,208,077.

Hole-transport layer (HTL) 104 provides the function of transporting holes to the emissive layer (EML) 105. HTL materials include various classes of aromatic amines as disclosed in commonly assigned US-A-4,720,432. A preferred class of HTL materials includes the tetraaryldiamines of formula (I). 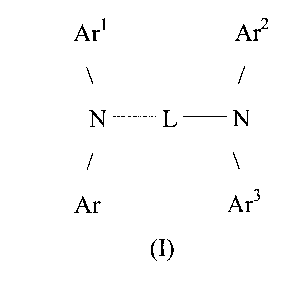 wherein:
Ar, Ar', Ar² and Ar³ are independently selected from among phenyl, biphenyl and naphthyl moieties;
L is a divalent naphthylene moiety or dₙ;
d is a phenylene moiety;
n is an integer of from 1 to 4; and
at least one of Ar, Ar¹, Ar² and Ar³ is a naphthyl moiety.

Useful selected (fused aromatic ring containing) aromatic tertiary amines are the following:
4,4'-Bis[N-(1-naphthyl)-N-phenylamino]biphenyl (NPB)
4,4"-Bis[N-(1 naphthyl)-N-phenylamino]-p-terphenyl
4,4'-Bis[N-(2-naphthyl)-N-phenylamino]biphenyl
1,5-Bis[N-( 1-naphthyl)-N-phenylamino]naphthalene
4,4'-Bis[N-(2-pyrenyl)-N-phenylamino]bi-phenyl
4,4'-Bis[N-(2-perylenyl)-N-phenylamino]biphenyl
2,6-Bis(di-p-tolylamino)naphthalene
2,6-Bis[di-(1-naphtyl)amino]naphthalene

Emissive layer 105 of FIG. 1 provides the function of light emission produced as a result of recombination of holes and electrons in this layer. A preferred embodiment of the emissive layer 105 includes a host material doped with one or more fluorescent dyes. Using this host-dopant composition, highly efficient OLED devices can be constructed. Simultaneously, the color of the EL devices can be tuned by using fluorescent dyes of different emission wavelengths in a common host material. Tang and others in commonly assigned US-A-4,769,292 has described this dopant scheme in considerable details for OLED devices using Alq as the host material. As set forth in the Tang and others commonly assigned US-A-4,769,292, the emissive layer can contain a green light-emitting doped material, a blue light-emitting doped material, or a red light-emitting doped material.

Preferred host materials include the class of 8-quinolinol metal chelate compounds with the chelating metals being Al, Mg, Li, Zn, for example. Another preferred class of host materials includes anthracene derivatives such as 9,10 dinaphthyl anthracene; 9,10 dianthryl anthracene; and alkyl substituted 9,10 dinaphthyl anthracene, as disclosed in Shi and others commonly assigned US-A-5,935,721.

Dopant materials include most fluorescent and phorphorescent dyes and pigments. Preferred dopant materials include coumarins such as coumarin 6, dicyanomethylenepyrans such as 4-dicyanomethylene-4H pyrans, as disclosed in Tang and others commonly assigned US-A-4,769,292 and in Chen and others in commonly assigned US-A-6,020,078.

Electron-transport layer 106 of FIG. 1 provides the function of delivering electrons injected from the cathode to emissive layer 105 of FIG. 1. Useful materials include Alq, benzazoles, as disclosed in commonly assigned Shi and others commonly assigned US-A-5,645,948.

Buffer layer 107 of FIG. 1 serves the function of controlling sputter damage during deposition of sputtered cathode 108 and thereby preserves the integrity of the active layer of the device. In accordance with the present invention it has been found that a buffer layer 107 including a compound of an alkali metal or thermal decomposition products thereof in conjunction with a sputtered layer of a reactive metal or alloy make highly efficient electron injecting contact to ETL layer 106. The advantageous results from using a single layered buffer only several nanometers thick and including a wide variety of materials are indeed quite unexpected. Buffer layers 107 can be selected from this group to have high and uniform transparency in the visible wavelength range. The portion of emitted light that strikes the cathode surface must first pass through the buffer layer 107. For standard (bottom-emitting) device, the light is reflected back from sputtered cathode 108 and directed toward the anode side. For top-emitting device, the light passes through the sputtered cathode 108. In either case, the light emerges with insignificant preferential attenuation of light in the visible wavelength range. These buffer layers are therefore suitable for fabricating full color devices. The alkali metal compounds that are particularly useful include RbN_{O}3, CsNO₃, Cs₂SO₄, KIO₃ or CsOOCCH₃ or their thermal decomposition products or combinations thereof. These materials can be deposited in a thin film form using conventional vapor deposition methods. Some alkali metal compounds may decompose during thermal evaporation and the composition of the layer deposited on the ETL can differ from the evaporation charge. Since, in general, they are electrical insulators, the buffer layer 107 of FIG. 1 needs to be thin but should be thick enough to provide significant protection against sputter damage.

Sputtered cathode 108 of FIG. is typically a fully reflective thin film, several tens of nm thick, and comprised of materials including alloys capable of efficiently injecting electron to the ETL 106 of FIG. 1. For surface emitting devices, the cathode layers can be made substantially transmissive by minimizing its thickness. Mg and Li containing alloys are generally vapor deposited directly on the ETL 106 of FIG. 1 because they have low work functions and make efficient electron-injecting contact to the ETL 106 of FIG. 1. A bilayer structure, LiF/Al, also provides efficient electron injection to the ETL 106. Aluminum, a high work function metal, injects electrons very inefficiently when deposited directly on Alq electron-transport layer 106. It has been determined in the present invention that efficient cathodes can be fabricated by sputtering Al or Mg over a thin buffer layer of compound of alkali metal that are vapor deposited on the ETL 106 of FIG. 1. The metals other than Mg and Al may also make efficient electron injecting contact in combination with the buffer layer, and these can include silicon, scandium, titanium, chromium, manganese, zinc, yittrium zirconium, or hafnium, or metal alloys thereof.

Although the FIG. 1 embodiment is believed preferred, it will be appreciated by those skilled in the art that a device can also be made which does not use hole-injection layer 103, hole-transport layer 104, and electron-transport layer 106. Those skilled in the art will appreciate that the emissive layer 105 can be selected to include hole-transport and electron-transport functions and the anode layer can function as the hole-injection layer 103. In such an instance, the device requires 105 and does not require layers 103, 104, and 106.

### EXAMPLES

In the following examples, reference should be made to Table 1 for the appropriate structure and operating parameters corresponding to the listed acronym

Unless otherwise stated, the basic organic EL medium includes a 75 nm NPB hole-transport layer (HTL) and a 60 nm Alq emitting and electron-transport layer (EML/ETL) deposited on a 42 nm thick ITO anode layer on glass substrates. The NPB and Alq layers were coated in a vacuum coater in single-pump down runs. A batch of these samples was then transferred to a multifunction coater where the remaining layers were deposited in proper sequence to generate various device configurations.

The multifunction coater was equipped with evaporation boats and crucibles, and 2 inch diameter sputter guns. Alkali metal compounds were evaporated from resistively heated boats, and Al for control device (also termed as standard or standard cathode cell) was evaporated from a crucible by electron beam heating in high vacuum. For sputtering, the deposition chamber was backfilled with pure Ar flowing at 30SCCM to maintain a fixed pressure, typically 16 mT (milli-Torr). The sputtering deposition was carried out by applying DC power to targets of pure Mg or Al. The deposition rate for Mg was 1.2 nm/s at 80 W, and that for Al was 1.0 nm/s at 100W. It is recognized that deposition rate can easily be controlled by selecting sputtering parameters. Although sputtering from a single target was used, simultaneous sputtering of multiple targets can be employed for increased process throughput. RF, instead of DC, can be used as an alternate power source. It is conceived that instead of a metal layer, an alloy layer with improved properties can be utilized. It is also understood that cosputtering of several targets, instead of sputtering from a single alloy target, can be employed for adjusting the composition of the alloy layer. The completed devices were encapsulated in a glove box in nitrogen atmosphere and given at times an optional heat treatment for several hours at about 70 C. The luminance was then determined as a function of drive current using a PR650 radiometer. The drive voltage V (volt) and luminance L (cd/m²) given the tables are those determined when a current corresponding to 20 mA/cm² was passed through the devices.

### Example 1

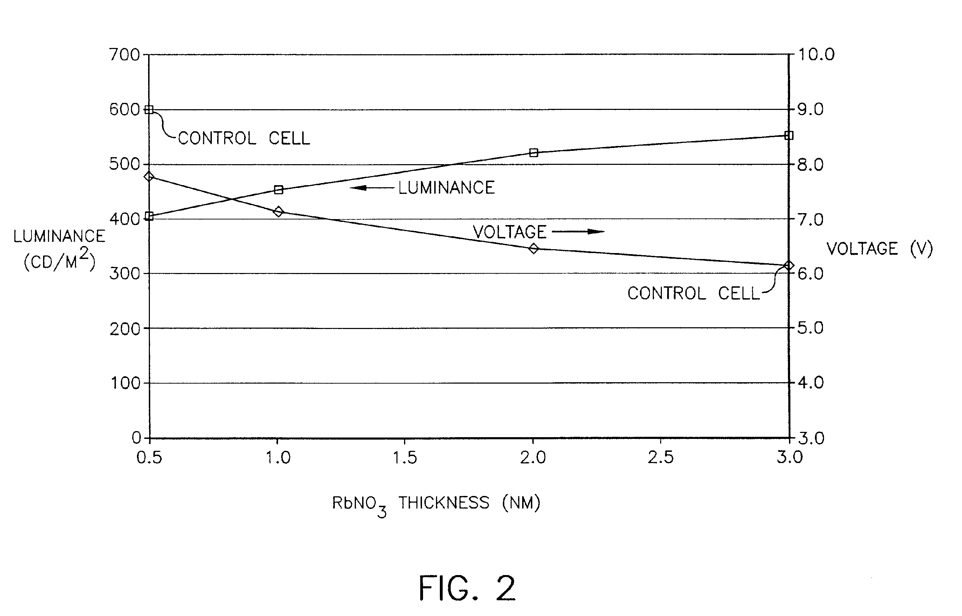

Table 2 compiles the buffer and cathode structure for an organic EL medium and the performance of resultant devices of the present invention and those of a control device. The ITO, HIL, HTL and EML/ETL layers of devices 20 through 24 are identical, and the organic layers were deposited in a single-pump-down run. The control device, 20, which was provided with a standard cathode including a 60 nm thick Al layer on a 0.5 nm LiF layer, exhibits a luminance of 600 cd/m² and an operating voltage of 6.2 volt. This device is assumed free of damage during cathode deposition. The device 21 has 0.5 nm RbNO₃ buffer layer and a Mg layer, 60 nm thick, was sputtered on the buffer layer. This device exhibits degraded performance, as evidenced by its high operating voltage and low efficiency relative to the control device, 20. The degradation is very likely due to damage induced during sputtering of Mg, as thermally evaporated Mg is known to make efficient electron injecting contact to Alq layer. Thus, 0.5 nm RbNO₃ was not completely protected against sputter damage. Relative to the control device, 20, the rise in operating voltage and loss in luminance efficiency for the device 21 is 1.6 V and 33%, respectively. The device 22 was provided with a 1 nm thick RbNO₃ layer on which a 60 nm thick Mg layer was sputtered under the same conditions as those for the device 21. The device 22 shows a luminance of 456 cd/m² and an operating voltage of 7.2 V indicating markedly improved performance over that of the device 21. This improvement is believed to originate from greater protection offered by thicker RbNO₃ layer during sputtering deposition of the Mg layer. The performance of the device 22, however, falls short of that of the control device 20. In the structure of device 23 incorporated is a 2 nm thick RbNO₃ buffer layer. The thicker buffer layer of device 23 provides better protection against sputter damage and exhibits an improvement over device 22 in operating voltage and luminance. Increasing the RbF thickness to 3 nm did further improve the device performance. Although the operating voltage of device 23 is identical to that of the control device 20, the loss in luminescence efficiency relative to the control device 20 is 6%. This indicates that a buffer layer thickness greater than 3 nm is needed for elimination of damage during sputtering deposition of the Mg layer. The performance of sputtered devices as a function of RbNO₃ buffer layer thickness (device 21 through 24) along with that of the control device 20 is also shown in FIG. 2. It is seen that the optimum RbNO₃ buffer layer thickness is greater than 3 nm for Mg sputtering.

**Table 2.**

| **Buffer, Cathode Structure, and Performance of a Control and Sputtered Cathode Devices.** | | | | | | | |
|---|---|---|---|---|---|---|---|
| Device ID | Device Type | LiF (nm) | Buffer RbNO₃ (nm) | Evaporated Al (nm) | Sputtered Mg (nm) | Drive Voltage (v) | Luminance (cd/m²) |
| 20 | Control | 0.5 | | 60 | | 6.2 | 600 |
| 21 | Sputtered Cathode | | 0.5 | | 60 | 7.8 | 404 |
| 22 | Sputtered Cathode | | 1.0 | | 60 | 7.2 | 456 |
| 23 | Sputtered Cathode | | 2.0 | | 60 | 6.5 | 523 |
| 24 | Control | | 3.0 | | 60 | 6.2 | 564 |

### Example 2

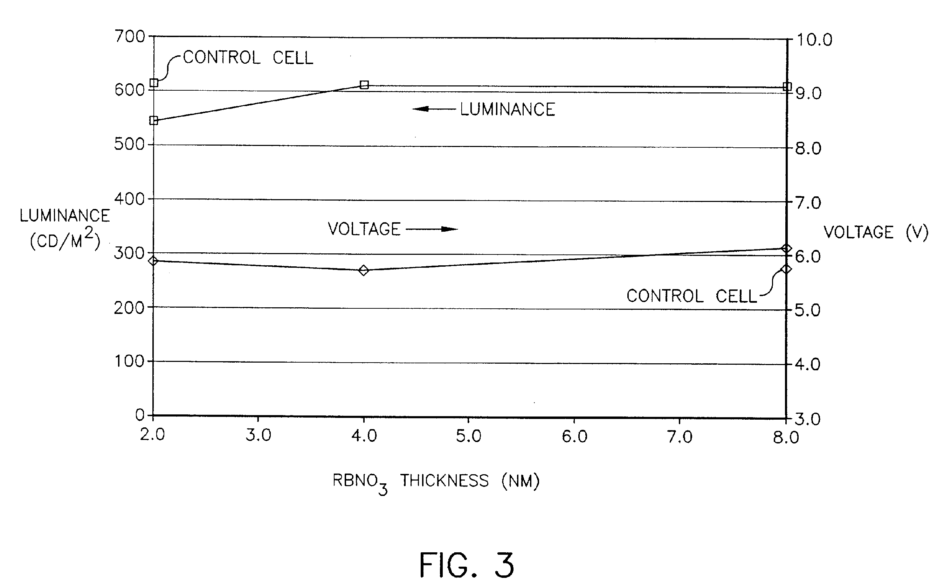

Table 3 compiles the buffer and cathode structure for an organic EL medium and the performance of resultant devices of the present invention and those of a control device. The range of RbNO₃ buffer layer thicknesses is extended over that of Example 1. The ITO, HIL, HTL and EML/ETL layers of devices 30 through 33 are identical and the organic layers were deposited in a single-pump-down run. The control device 30, which was provided with a standard cathode includes a 60 nm thick Al layer on a 0.5 nm thick LiF layer, exhibits a luminance of 608 cd/m² and an operating voltage of 5.7 V. Again this device is assumed free of damage during cathode deposition as the cathode layer was evaporated. The device 31 was provided with a 2 nm thick RbNO₃ layer on which a 60 nm thick Mg layer was sputtered. The device 31 shows a luminance of 545 cd/m² and an operating voltage of 5.9 V indicating that 2 nm thick RbNO₃ buffer layer provides excellent protection against sputter damage. However, the luminance loss relative to the control device 30 is about 10%. In the structure of device 32 incorporated is a 4 nm thick RbNO₃ buffer layer. The thicker buffer layer of device 32 provides better protection against sputter damage and exhibits an improvement over device 31 in operating voltage and luminance. The performances of the device 32 and control device 30 appear equal. The data suggests that sputter damage in device 32 is virtually eliminated. Increasing the RbNO₃ thickness to 8 nm causes the operating voltage to increase. Thus, RbNO₃ buffer layer, about 4 nm thick has resulted in elimination or minimization of damage during sputtering deposition of the Mg layer. The performance of sputtered devices as a function of RbNO₃ buffer layer thickness (device 31 through 33) along with that of the control device 30 is also shown in FIG. 3.

**Table 3.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer RbNO₃ (nm) | Evaporated Al (nm) | Sputtered Mg (nm) | Drive Voltage (v) | Luminance (cd/m²) |
| 30 | Control | 0.5 | | 60 | | 5.7 | 608 |
| 31 | Sputtered Cathode | | 2.0 | | 60 | 5.9 | 545 |
| 32 | Sputtered Cathode | | 4.0 | | 60 | 5.7 | 613 |
| 33 | Sputtered Cathode | | 8.0 | | 60 | 6.1 | 618 |

### Example 3

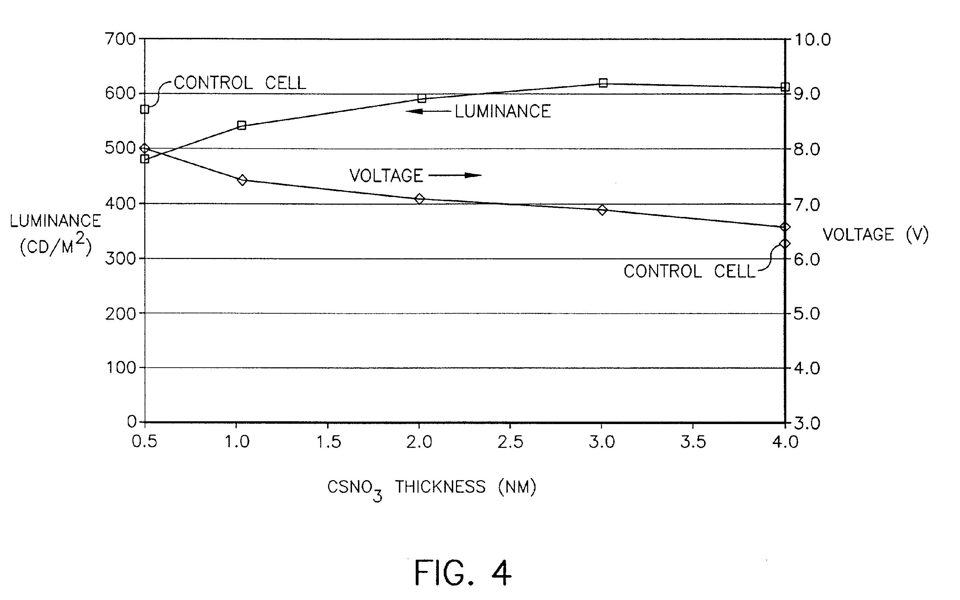

Table 4 compiles the buffer and cathode structure for an organic EL medium and the performance of resultant devices of the present invention and those of a control device. The ITO, HIL, HTL and EML/ETL layers of devices 40 through 45 are identical, and the organic layers were deposited in a single pump-down run. The control device 40, which was provided with a standard cathode including a 60 nm thick Al layer on a 0.5 nm LiF layer, exhibits a luminance of 571 cd/m² and an operating voltage of 6.5 volt. This device is assumed free of damage during cathode deposition. The device 41 was provided with a 0.5 nm thick CsNO₃ layer on which a 60 nm thick Mg layer was sputtered. The device 41 shows a luminance only of 485 cd/m² and an operating voltage of 8.0 V, indicating that 0.5 nm CsNO₃ buffer layer does not offer complete protection against sputtering damage to EL medium. The rise in operating voltage and loss in luminance efficiency for the device 41, relative to the control device 40, is 1.5 V and 15 %, respectively. Increasing the CsNO₃ buffer layer thickness to 1.0 nm results in improvements in operating voltage and luminance efficiency and beyond that the voltage improves and the luminance appears leveled off. At the CsNO₃ layer thickness of about 4 nm the damage appears to have been minimized or eliminated during sputtering deposition of the Mg layer. The performance of sputtered devices as a function of CsNO₃ buffer layer thickness (devices 41 through 45) along with that of the control device 40 is also shown in FIG. 4.

**Table 4.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer CsNO₃ (nm) | Evaporated Al (nm) | Sputtered Mg (nm) | Drive Voltage (v) | Luminance (cd/m²) |
| 40 | Control | 0.5 | | 60 | | 6.5 | 571 |
| 41 | Sputtered Cathode | | 0.5 | | 60 | 8.0 | 485 |
| 42 | Sputtered Cathode | | 1.0 | | 60 | 7.6 | 534 |
| 43 | Sputtered Cathode | | 2.0 | | 60 | 7.1 | 589 |
| 44 | Sputtered Cathode | | 3.0 | | 60 | 6.9 | 618 |
| 45 | Sputtered Cathode | | 4.0 | | 60 | 6.7 | 610 |

### Example 4

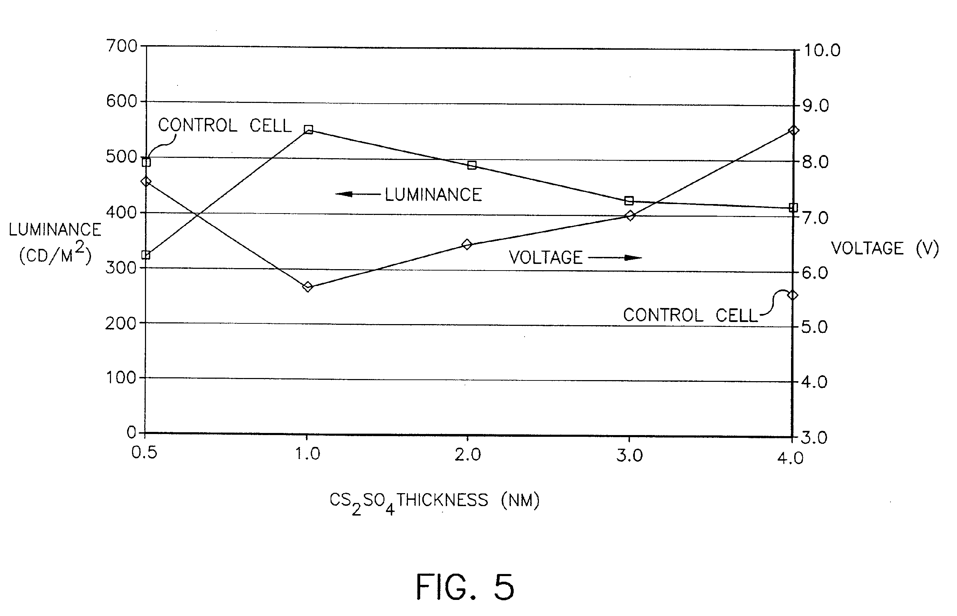

Table 5 compiles the buffer and cathode structure for an organic EL medium and the performance of resultant devices of the present invention and those of a control device. The ITO, HIL, HTL and EML/ETL layers of devices 50 through 55 are identical, and the organic layers were deposited in a single pump-down run. The control device 50, which was provided with a standard cathode including a 60 nm thick Al layer on a 0.5 nm LiF layer, exhibits a luminance of 495 cd/m² and an operating voltage of 5.6 volt. The device 51 has no buffer layer; Mg layer, 60 nm thick, was directly sputtered on the Alq ETL layer. The device 51 data suggest severe sputter damage to EL medium as evidenced by its high operating voltage of 7.6 V and low luminance of 330 cd/m² relative to the control device 50, which is assumed free of damage during cathode deposition. The device 52 was provided with a 1 nm thick Cs₂SO₄ layer, upon which a 60 nm thick Mg layer was sputtered. The device 52 shows a luminance only of 554 cd/m² and an operating voltage of 5.7 V indicating that 1 nm Cs₂SO₄ buffer layer has virtually eliminated damage during sputtering deposition of the Mg layer. Increasing the Cs₂SO₄ buffer layer thickness beyond 1.0 nm monotonically increases the operating voltage and decreases the luminance efficiency. The performance of sputtered devices as a function of Cs₂SO₄ buffer layer thickness (devices 51 through 55) along with that of the control device 50 is also shown in FIG. 5.

**Table 5.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer Cs₂SO₄ (nm) | Evaporated Al (nm) | Sputtered Mg (nm) | Drive Voltage (v) | Luminance (cd/m²) |
| 50 | Control | 0.5 | | 60 | | 5.6 | 495 |
| 51 | Sputtered Cathode | | | | 60 | 7.6 | 330 |
| 52 | Sputtered Cathode | | 1.0 | | 60 | 5.7 | 554 |
| 53 | Sputtered Cathode | | 2.0 | | 60 | 6.6 | 491 |
| 54 | Sputtered Cathode | | 3.0 | | 60 | 7.0 | 448 |
| 55 | Sputtered Cathode | | 4.0 | | 60 | 8.7 | 413 |

### Example 5

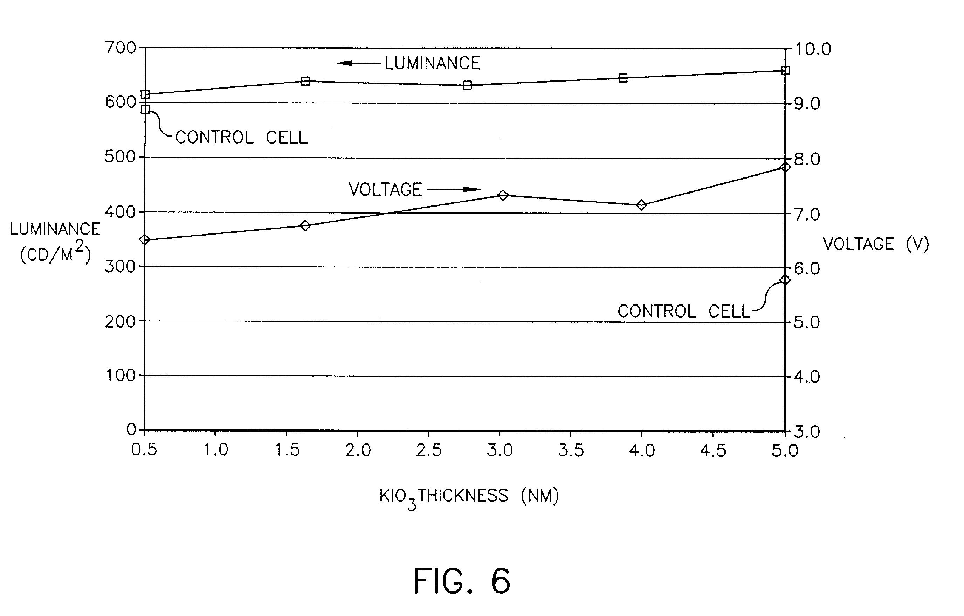

Table 6 compiles the buffer and cathode structure for an organic EL medium and the performance of resultant devices of the present invention and those of a control device. The ITO, HIL, HTL and EML/ETL layers of devices 60 through 65 are identical, and the organic layers were deposited in a single pump-down run. The control device 60, which was provided with a standard cathode including a 60 nm thick Al layer on a 0.5 nm LiF layer, exhibits a luminance of 590 cd/m² and an operating voltage of 5.8 V. This device is assumed free of damage during cathode deposition. The device 61 has 0.5 nm KIO₃ buffer layer over which Mg layer, 60 nm thick, was sputtered. This device exhibits exhibits slightly higher operating voltage but about the same luminance as the control device 60. The device 62 was provided with a 1.5 nm thick KIO₃layer; otherwise the device structure is similar to that of the device 61. The device 62 shows a luminance of 638 cd/m² and an operating voltage of 6.7 V indicating performance approximately similar to that of the device 61. The data for the devices 61 and 62 suggest that sputter damage has been greatly minimized. Increasing the KIO₃ buffer layer thickness beyond 1.5 nm as in the devices 63 through 65 monotonically increases the operating voltage but luminance appears leveled off. The performance of sputtered devices as a function of buffer KIO₃ layer thickness (devices 61 through 65) along with that of the control device 60 is also shown in FIG.6.

**Table 6.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer KIO₃ (nm) | Evaporated Al (nm) | Sputtered Mg (nm) | Drive Voltage (v) | Luminance (cd/m²) |
| 60 | Control | 0.5 | | 60 | | 5.8 | 590 |
| 61 | Sputtered Cathode | | 0.5 | | 60 | 6.5 | 610 |
| 62 | Sputtered Cathode | | 1.5 | | 60 | 6.7 | 638 |
| 63 | Sputtered Cathode | | 3.0 | | 60 | 7.3 | 630 |
| 64 | Sputtered Cathode | | 4.0 | | 60 | 7.1 | 643 |
| 65 | Sputtered Cathode | | 5.0 | | 60 | 7.9 | 663 |

### Example 6

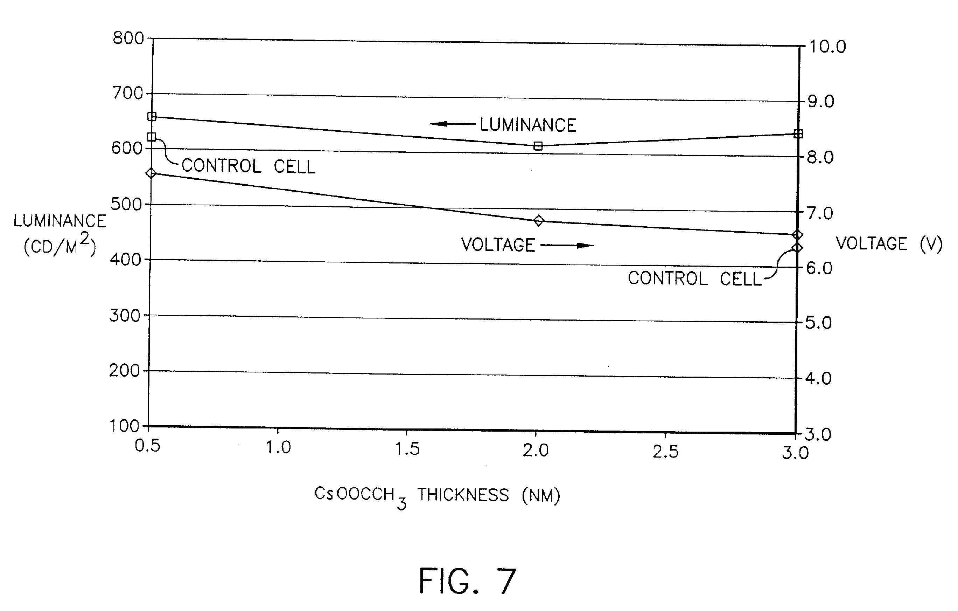

Table 7 compiles the buffer and cathode structure for an organic EL medium and the performance of resultant devices of the present invention and those of a control device. The ITO, HIL, HTL and EML/ETL layers of devices 70 through 73 are identical, and the organic layers were deposited in a single pump-down run as in the previous examples. The control device 70, which was provided with a standard cathode including a 60 nm thick Al layer on a 0.5 nm LiF layer, exhibits a luminance of 612 cd/m² and an operating voltage of 6.5 volt. The device 70 is assumed free of damage as the cathode was deposited by evaporation. The device 71 has 0.5 nm CsOOCCH₃ buffer layer over which Mg layer, 60 nm thick, was sputtered. This device exhibits higher operating voltage but about identical luminance compared to those of the control device 70. Increasing the CsOOCCH3 buffer layer thickness to 2 or 3 nm as in the devices 72 and 73, monotonically decreases the operating voltage but luminance appears leveled off. The performance of sputtered devices as a function of CsOOCCH₃ buffer layer thickness (devices 71 through 73) along with that of the control device 70 is also shown in FIG. 6. According to FIG. 7 damage due to Mg sputtering is minimized when a CsOOCCH₃ buffer layer about 3 nm thick is used.

**Table 7.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer CsOOCCH₃ (nm) | Evaporated Al (nm) | Sputtered Mg (nm) | Drive Voltage (v) | Luminance (cd/m²) |
| 70 | Control | 0.5 | | 60 | | 6.5 | 612 |
| 71 | Sputtered Cathode | | 0.5 | | 60 | 7.5 | 647 |
| 72 | Sputtered Cathode | | 2.0 | | 60 | 6.9 | 609 |
| 73 | Sputtered Cathode | | 3.0 | | 60 | 6.6 | 630 |

### Example 7

Table 8 compiles the buffer and cathode structure for an organic EL medium and the performance of a resultant device of the present invention and those of a control device. The ITO, HIL, HTL, and EML/ETL layers of devices 80 and 81 are identical, and the organic layers were deposited in a single-pump-down run. The control device 80 was provided with a standard cathode including a 60 nm thick evaporated Al layer on a 0.5 nm LiF layer. The device 80 exhibits a luminance of 514 cd/m² and an operating voltage of 5.9 V. The characteristic of device 80 is assumed to represent that of a device the cathode of which was deposited by a damage free process. The device 81 was provided with a 2 nm RbNO₃ buffer layer on which a 72 nm thick Al layer was sputtered. The device 81 shows a luminance of 491 cd/m² and an operating voltage of 6.6 V, indicating that the 2 nm RbNO₃buffer layer greatly reduced damage during sputtering deposition of Al layer.

**Table 8.**

| **Buffer, Cathode Structure, and Performance of a Control and a Sputtered Cathode Device** | | | | | | | |
|---|---|---|---|---|---|---|---|
| Device ID | Device Type | LiF (nm) | Buffer RbNO₃ (nm) | Evaporated Al (nm) | Sputtered Al (nm) | Drive Voltage (v) | Luminance (cd/m²) |
| 80 | Control | 0.5 | | 60 | | 5.9 | 514 |
| 81 | Sputtered Cathode | | 2.0 | | 72 | 6.6 | 491 |

### Example 8

Table 9 compiles the buffer and cathode structure for an organic EL medium and the performance of resultant devices of the present invention and those of a control device. In this example the ITO, HIL, HTL, and EML/ETL layers of devices 90 through 92 are identical, and the organic layers were deposited in a single-pump-down run. The control device, 90, which was provided with a standard cathode including a 60 nm thick Al layer on a 0.5 nm LiF layer, exhibits a luminance of 612 cd/m² and an operating voltage of 6.4 volt. The device 90 is assumed to be free of damage as the cathode was evaporated. The device 91 was provided with a 2 nm thick CsOOCCH₃ buffer layer on which a 72 nm thick Al layer was sputtered. The device 91 shows a luminance only of 499 cd/m² and an operating voltage of 8.3 V, indicating that the 2 nm thick CsOOCCH₃ buffer layer greatly reduced but not completely eliminated damage during sputtering deposition of Al. The device 92, which was provided with a 2.5 nm thick RbNO₃ buffer layer, has exhibited superior performance. The EL efficiency is same as that of the control cell but the drive voltage is slightly higher. It is believed that due to high sputtering power used for Al sputtering residual damage existed in the device and that the damage could have been eliminated by optimization of the buffer layer thickness and sputtering parameters.

**Table 9.**

| **Buffer, Cathode Structure, and Performance of a Control and Sputtered Cathode Devices** | | | | | | | |
|---|---|---|---|---|---|---|---|
| Device ID | Device Type | LiF (nm) | Buffer (nm) | Evaporated Al (nm) | Sputtered Al (nm) | Drive Voltage (v) | Luminance (cd/m²) |
| 90 | Control | 0.5 | | 60 | | 6.4 | 612 |
| 91 | Sputtered Cathode | | CsOOCCH₃ (2.0) | | 72 | 8.3 | 499 |
| 92 | Sputtered Cathode | | RbNO₃ (2.5) | | 72 | 7.3 | 613 |

The above examples show that a thin layer comprising a compound of an alkali metal deposited over the Alq ETL offers significant protection to EL medium during sputtering deposition of Al and Mg cathode layer. In accordance with the present invention, buffer layer including an alkali metal compound including RbNO₃, CsNO₃, Cs₂SO₄, KIO₃ or CsOOCCH₃ or combinations thereof can be very effective in protecting organic EL media from damage during sputtering deposition of cathode layers. Also in accordance with the present invention the metal or metal alloys includes magnesium, aluminum, silicon, scandium, titanium, chromium, manganese, zinc, yittrium, zirconium or hafnium, or metal alloys or combinations thereof that in conjunction with the buffer layer, inject electron to the ETL can be useful. Preferably the metal or metal alloys include aluminum or magnesium or metal alloys or combinations thereof. It is believed that such a buffer layer, several nanometers thick, can virtually eliminate sputter damage. The useful thickness of buffer layer is less than 10 nm but greater than 0 nm. More appropriately the buffer thickness should preferably be in the range of 0.5 to 5.0 nm. The sputtered cathode device through optimization of layer structure and sputtering parameters can be made essentially equal in performance to control device having an evaporated LiF/Al cathode.

Other features of the invention are included below.

The OLED device wherein the emissive layer includes Alq.

The OLED device wherein the emissive layer contains one or more light-emitting dopant materials.

The OLED device wherein the emissive layer includes Alq.

The OLED device wherein the electron-transport layer includes Alq.

The OLED device wherein the emissive layer contains one or more light-emitting dopant materials.

A method of making an OLED device, comprising the steps of:
a) providing a substrate;
b) forming an anode of a conductive material over the substrate;
c) depositing an emissive layer having an electroluminescent material provided over the anode layer;
d) forming a buffer layer, provided over the emissive layer and including a compound of an alkali metal or thermal decomposition products thereof;
e) sputtering a metal or metal alloy layer provided over the buffer layer. and selected to function with the buffer layer to inject electrons; and
f) heat treating in an inert dry atmosphere.

The method wherein the sputtering is accomplished using either DC or RF power.

The method wherein the sputtering is accomplished by sputtering materials from one or more targets.

The method wherein the buffer layer has a thickness less than 10 nm but greater than 0 nm.

The method wherein the buffer layer has a thickness less than 5 nm but greater than 0.5 nm.

## Claims

1. An OLED device, comprising:
a) a substrate;
b) an anode formed of a conductive material over the substrate;
c) an emissive layer having an electroluminescent material provided over the anode layer;
d) a buffer layer, provided over the emissive layer and including a compound of an alkali metal or thermal decomposition products thereof; and
e) a sputtered layer of a metal or metal alloy provided over the buffer layer and selected to function with the buffer layer to inject electrons.

2. The OLED device of claim 1 wherein the alkali metal compounds include RbNO₃, CsNO₃, Cs₂SO₄, KIO₃ or CsOOCCH₃, or their thermal decomposition products or the combinations thereof.

3. The OLED device of claim 2 wherein the buffer layer has a thickness less than 10 nm but greater than 0 nm.

4. The OLED device of claim 2 wherein the buffer layer has a thickness less than 5 nm but greater than 0.5 nm.

5. The OLED device of claim 1 wherein the metal or metal alloys include aluminum or magnesium or metal alloys or combinations thereof.

6. The OLED device of claim 1 wherein the metal further includes silicon, scandium, titanium, chromium, manganese, zinc, yittrium, zirconium or hafnium, or metal alloys, or combinations thereof

7. An OLED device, comprising:
a) a substrate;
b) an anode formed of a conductive material over the substrate;
c) a hole-injection layer provided over the anode layer;
d) a hole-transport layer provided over the hole-injection layer;
e) an emissive layer having an electroluminescent material provided over the hole-transport layer;
f) an electron-transport layer provided over the emissive layer;
g) a buffer layer, provided over the electron-transport layer and including a compound of an alkali metal or thermal decomposition products thereof; and
h) a sputtered layer of a metal or metal alloy provided over the buffer layer and selected to function with the buffer layer to inject electrons.

8. The OLED device of claim 7 wherein the buffer layer has a thickness less than 10 nm but greater than 0 nm.

9. The OLED device of claim 7 wherein the buffer layer has a thickness less than 5 nm but greater than 0.5 nm.

10. The OLED device of claim 7 wherein the alkali metal compounds include RbNO₃, CsNO₃, Cs₂SO₄, KIO₃ or CsOOCCH₃, or their thermal decomposition products or the combinations thereof.

11. The OLED device of claim 7wherein the metal or metal alloys include aluminum or magnesium or metal alloys or combinations thereof.

12. The OLED device of claim 7 wherein the metal further includes silicon, scandium, titanium, chromium, manganese, zinc, yittrium, zirconium or hafnium, or metal alloys, or combinations thereof.
